Europäisches Patentamt

(19) European Patent Office   (11) Publication number:   **0 032 801**
Office européen des brevets                          **B1**

(12)                    EUROPEAN PATENT SPECIFICATION

(45) Date of publication of patent specification: **03.09.86**   (51) Int. Cl.⁴: **H 01 L 21/302**

(21) Application number: **81300122.9**

(22) Date of filing: **13.01.81**

(54) Method of dicing a semiconductor wafer.

(30) Priority: **22.01.80 JP 6079/80**

(43) Date of publication of application:
**29.07.81 Bulletin 81/30**

(45) Publication of the grant of the patent:
**03.09.86 Bulletin 86/36**

(84) Designated Contracting States:
**DE FR GB NL**

(56) References cited:
**FR-A-1 480 433**
**GB-A-1 118 536**
**US-A-4 033 027**

(73) Proprietor: **Kabushiki Kaisha Toshiba**
**72, Horikawa-cho Saiwai-ku**
**Kawasaki-shi Kanagawa-ken 210 (JP)**

(72) Inventor: **Abe, Masahiro**
**1020 Hiyoshihoncho Kohoku-ku**
**Yokohama-shi (JP)**
Inventor: **Miyagawa, Masafumi**
**3-18-4 Yookodai**
**Sagamihara-shi Kanagawa-ken (JP)**
Inventor: **Nakamura, Hatsuo**
**11-11 Kaminokida**
**Kanagawa-ku Yokohama-shi (JP)**
Inventor: **Yonezawa, Toshio**
**6-20-46 Kugocho**
**Yokosuka Kanagawa-ken (JP)**

(74) Representative: **Shindler, Nigel et al**
**BATCHELLOR, KIRK & EYLES 2 Pear Tree Court**
**Farringdon Road**
**London EC1R 0DS (GB)**

Courier Press, Leamington Spa, England.

## Description

This invention relates to a method of dicing a semiconductor wafer.

With most semiconductor products, for example, transistors, diodes, light emitting diodes, and integrated circuits, a large number of elements are manufactured simultaneously on a large semiconductor wafer of Si, GaP, GaAs, sapphire etc. The semiconductor industry employs the term "dicing technologies" to refer to those techniques for dividing up a semiconductor wafer to obtain a large number of high quality pellets. Two dicing methods are particularly well known in the art. These are the grinding-cutting method, using a wire bladed saw, and the scribing method, using a diamond point. When laying out the pattern of pellets on the surface of the semiconductor wafer, the distance between adjacent pellets has been minimized to maximize efficiency.

However, there are three restrictions upon the minimum distance attainable between adjacent pellets. The first restriction is the actual dicing width, the second restriction is the degree of precision to which the cutting machine can be adjusted, and the third restriction is the extent of the cracks and chips extending horizontally from the dicing line. Of these restrictions, the third, namely the generation of cracks and chips, creates the most significant limitation with respect to minimizing the distance between adjacent pellets.

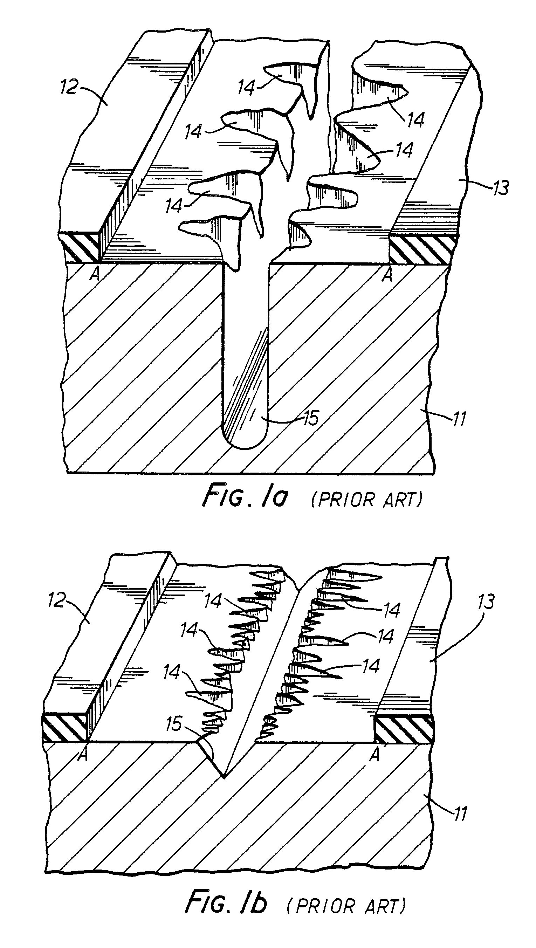

FIGURE 1a illustrates the effect of the traditional grinding-cutting method, and FIGURE 1b illustrates the effect of the traditional scribing method. Similar elements in these FIGURES are assigned the same reference numbers. A semiconductor substrate 11 carries many active element areas such as 12, 13 (not shown in detail), and dicing occurs in the space between the adjacent active element areas 12, 13. Many cracks and chips 14 are generated horizontally from a dicing line 15. Therefore, the distance between active element areas 12, 13 (shown in FIGURES 1a and 1b as distance A—A) has to be 100—200 µm to prevent the active element areas 12, 13 from being influenced by cracks and chips 14.

This invention seeks to provide an improved method of dicing a semiconductor wafer to prevent cracks and chips along the dicing line from spreading to the active areas.

Accordingly the present invention provides a method of preparing a semiconductor wafer for dicing, said wafer having circuit element areas separated by a region of a single conductivity type extending beneath and on both sides of a predetermined dicing line which is positioned so that it does not intersect any PN junction, the said method comprising the steps of:

forming in said region of a single conductivity type two grooves delimiting an intermediate region in which the dicing line extends, the bottoms of said grooves being at a lower level than the surface of said intermediate region and the distance between the grooves being such that a division to be formed in the semiconductor wafer along the dicing line will be separated from each of said grooves, and

forming said division along the dicing line, the division being deeper than the grooves with respect to the surface of the intermediate region.

Some embodiments of the invention will now be described by way of example with reference to the accompanying drawings, in which:

FIGURES 1a and 1b are partly sectional, enlarged perspective views of devices manufactured by conventional techniques; and

FIGURES 2 and 3 are enlarged sectional views respectively, showing the principles of this invention and devices manufactured by the method of this invention.

Cracks and chips which are generated during dicing generally propagate in a direction perpendicular to the direction of maximum stress in the wafer. Thus, typically, cracks spread away from the dicing line into the wafer. However we have found that this propagation can be restrained by the formation of a stress concentration in the path of the crack. Thus, the transmission of the cracks and chips can be restrained by the formation of a physical discontinuity on the surface of the wafer on both sides of a predetermined dicing line.

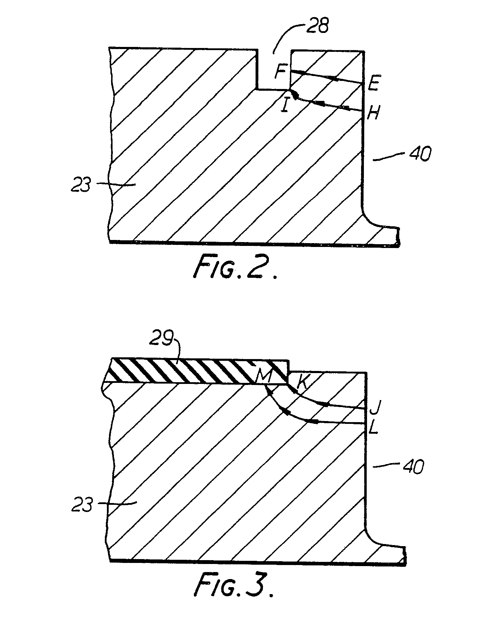

Referring now to Figures 2 and 3 of the drawings wherein like reference characters designate like or corresponding parts throughout the several views, active element areas (not shown) are formed on the surface of a substrate 23 and many circuit elements are manufactured in these areas. A groove 28 is formed over on either side of a predetermined cutting line on the surface of substrate 23 only one of these grooves being shown in the drawings. The depth of each groove is 3 to 4 µm. The groove should not be made mechanically, but by chemical photo-etching or any other non-mechanical method. Thereafter substrate 23 is ground or scribed along the predetermined line to form the groove 40. As a result of this method, the transmission of cracks and chips is stopped by the walls of the groove. Therefore, it is possible to reduce the distance between the active element areas 80—100 µm.

Cracks generated at points E and H spread to points F and I, respectively, and stop. Figure 3 shows another embodiment of this invention, which includes the step of forming a semiconductor oxide film 29 on and partially into the substrate to create a surface level change. For cracks generated at points J and L, the stress concentrations happen between points K and M, respectively, so that the cracks are restrained at points K and M.

Many changes and modifications in the above described embodiments can, of course, be carried out without departing from the scope of the present invention, that scope being defined only by the scope of the appended claims.

## Claims

1. A method of preparing a semiconductor wafer for dicing, said wafer having circuit element areas separated by a region of a single conductivity type extending beneath and on both sides of a predetermined dicing line which is positioned so that it does not intersect any PN junction, the said method comprising the steps of:

forming in said region of a single conductivity type two grooves delimiting an intermediate region in which the dicing line extends, the bottoms of said grooves being at a lower level than the surface of said intermediate region and the distance between the grooves being such that a division to be formed in the semiconductor wafer along the dicing line will be separated from each of said grooves, and

forming said division along the dicing line, the division being deeper than the grooves with respect to the surface of the intermediate region.

2. A method according to claim 1, wherein the level change on both sides of the intermediate region is achieved by forming a semiconductor oxide film on and partially into the substrate.

## Patentansprüche

1. Verfahren zur Verbereitung einer Halbleiterplatte zur Zerteilung, wobei die Halbleiterplatte Schaltelementbereiche aufweist, die durch einen Bereich mit einer einzigen Leitfähigkeitsart getrennt sind, der sich unterhalb und zu beiden Seiten einer vorgegebenen Zerteilungslinie erstreckt und der so angeordnet ist, daß er nicht irgendeinen PN-Übergang schneidet, wobei das Verfahren folgende Schritte aufweist:

in dem Bereich einer einzigen Leitfähigkeitsart werden zwei Rillen gebildet, die einen dazwischen liegenden Bereich eingrenzen, in dem sich die Zerteilungslinie erstreckt, wobei sich der Boden der Rillen auf einem tieferen Niveau befindet als die Oberfläche des genannten Zwischenbereichs und wobei der Abstand zwischen den Rillen so gewählt ist, daß eine in der Halbleiterplatte zu bildende Teilung entlang der Zerteilungslinie von jeder der genannten Rillen getrennt ist, und

die Teilung wird entlang der Zerteilungslinie durchgeführt, wobei die Teilung in bezug zu der Oberfläche des Zwischenbereichs tiefer ist als die Rillen.

2. Verfahren nach Anspruch 1, dadurch gekennzeichnet, daß der Niveausprung auf beiden Seiten des Zwischenbereichs durch die Bildung eines Halbleiteroxydfilms auf und teilweise in dem Substrat gebildet wird.

## Revendications

1. Procédé pour préparer une tranche de matière semi-conductrice à la division en plaquettes, ladite tranche comportant des surfaces ou des régions d'éléments de circuits séparées par une région ayant un seul mode de conduction s'étendant sous et de part et d'autre d'une ligne de division prédéterminée qui est placée de façon à ne pas couper une jonction p-n quelconque, caractérisé en ce qu'on forme dans ladite région n'ayant qu'un seul mode de conduction, deux rainures délimitant une région intermédiaire dans laquelle la ligne de division s'étend, les fonds desdites rainures étant à un niveau inférieur à celui de ladite région intermédiaire, tandis que la distance entre les rainures est telle qu'une division appelée à être formée dans la plaquette semi-conductrice le long de la ligne de division, sera séparée de chacune desdites rainures et, en ce qu'on forme ladite division le long de la ligne de division, la division étant plus profonde que les rainures, par rapport à la surface de la région intermédiaire.

2. Procédé selon la revendication 1, caractérisé en qu'on réalise le changement de niveau de part et d'autre de la région intermédiaire en formant une pellicule d'oxyde semi-conducteur sur et partiellement dans le substrat.

**FIG. 1a** (PRIOR ART)

**FIG. 1b** (PRIOR ART)

1

*28*

*F* *E*

*I* *H*

*23* *40*

**FIG.2.**

*29*

*M* *K* *J* *L*

*23* *40*

**FIG.3.**